# EUROPEAN PATENT APPLICATION

(11) **EP 2 068 162 A2**
(43) Date of publication of application: **10.06.2009**
(21) Application number: 08170059.3
(22) Date of filing: 27.11.2008
(51) Int. Cl.: G01R 31/36

(54) **Semiconductor integrated circuit device and battery pack**

(30) Priority: 06.12.2007 JP 2007316283; 23.10.2008 JP 2008272909
(71) Applicant: Mitsumi Electric Co., Ltd., Tama-shi, Tokyo 206-8567 (JP)
(72) Inventor: Itagaki, Takatoshi, Tama-Shi Tokyo 206-8567 (JP); Abe, Makio, Tama-Shi Tokyo 206-8567 (JP)
(74) Representative: Vinsome, Rex Martin

(57) **Abstract**

A semiconductor integrated circuit device for calculating a remaining battery capacity of a battery from which the semiconductor integrated circuit device receives power supply, and reporting the calculated remaining battery capacity to a battery-using appliance which also receives power supply from the battery includes a clock generating unit configured to generate a first clock signal and a second clock signal having a higher frequency than a frequency of the first clock signal; a selecting unit configured to select one of the first clock signal and the second clock signal and output the selected clock signal; a calculating unit configure to operate according to the selected clock signal to calculate the remaining battery capacity; and a communicating unit configured to operate according to the selected clock to report the calculated remaining battery capacity to the battery-using appliance.

## Description

### BACKGROUND OF THE INVENTION

### 1. Field of the Invention

The present invention herein is directed to a semiconductor integrated circuit device and a battery pack, in particular to a semiconductor integrated circuit device and a battery pack capable of obtaining a remaining battery capacity and reporting it to a battery-using appliance.

### 2. Description of the Related Art

In recent years, lithium ion batteries have been commonly used as power sources for various portable appliances such as portable telephones and digital cameras. As for lithium ion batteries, however, detection of the remaining battery capacity is considered difficult due to their voltage. Accordingly, the remaining battery capacity is obtained by integrating the charging/discharging current of the battery.

Conventionally, fuel gauge ICs for obtaining the remaining battery capacity by the above-mentioned technique have been developed. The fuel gauge ICs, which include a CPU and a memory, calculate the remaining battery capacity of a lithium ion battery used by a portable appliance by converting a detected charging/discharging current into digital data and integrating such digital data together, and transmit the calculated remaining battery capacity to the portable appliance through a communication circuit.

Such a fuel gauge IC is used to estimate the remaining battery capacity of a lithium ion battery; however, the fuel gauge IC itself draws power from the lithium ion battery for its operation. Therefore, it is necessary to minimize the consumption current of the fuel gauge IC.

Patent Document 1 discloses a technique of providing, during a control mode of a data process unit, a measurement mode to measure the remaining battery capacity of a battery, and performing control to reduce the current supplied from the battery to the minimum level, thereby saving power dissipation.

Japanese Laid-open Patent Application Publication No. 2005-12960

A conventional fuel gauge IC has, besides a normal mode, only a shutdown mode during which the clock is stopped or the power is cut off when the battery is left for a long period of time. Accordingly, the conventional fuel gauge IC is not capable of reducing the consumption current in accordance with the connection status of an appliance using the battery (hereinafter referred to simply as "battery-using appliance") to the battery and/or an operating condition of the battery-using appliance. Furthermore, the conventional fuel gauge IC is not capable of obtaining the remaining battery capacity after the battery is left for a long period of time without being connected to the battery-using appliance.

### SL3MMARY OF THE INVENTION

In view of the above-described problems, the present invention aims at providing a semiconductor integrated circuit device and a battery pack that allow various operation modes, each requiring a different amount of consumption current, to be set, and are capable of obtaining the remaining battery capacity and also reducing the consumption current according to the connection status and/or an operating condition of the battery-using appliance.

One aspect of the present invention may be to provide a semiconductor integrated circuit device for calculating a remaining battery capacity of a battery from which the semiconductor integrated circuit device receives power supply, and reporting the calculated remaining battery capacity to a battery-using appliance which also receives power supply from the battery. The semiconductor integrated circuit device includes a clock generating unit configured to generate a first clock and a second clock having a higher frequency than a frequency of the first clock; a selecting unit configured to select one of the first clock and the second clock and output the selected clock; a calculating unit configured to operate according to the selected clock to calculate the remaining battery capacity; and a communicating unit configured to operate according to the selected clock to report the calculated remaining battery capacity to the battery-using appliance.

### BRIEF DESCRIPTION OF THE DRAWINGS

FIG. 1 is a block diagram showing a structure of a semiconductor integrated circuit device according to one embodiment of the present invention;
FIG. 2 shows mode switching of the semiconductor integrated circuit device;
FIG. 3 is a flowchart showing one embodiment of an operation mode switching process;
FIGs. 4A and 4B are diagrams illustrating mode switching;
FIG. 5 is a perspective view of a battery pack to which the semiconductor integrated circuit device of one embodiment of the present invention is applied;
FIG. 6 is a block diagram showing another structure of the semiconductor integrated circuit device according to one embodiment of the present invention;
FIG. 7 shows a configuration of a variable oscillator circuit according to one embodiment of the present invention;
FIG. 8 shows mode transitions of the semiconductor integrated circuit device of FIG. 6;
FIG. 9 is a flowchart showing another embodiment of the operation mode switching process; and
FIG. 10 is a diagram illustrating mode switching.

### DETAILED DESCRIPTION OF THE PREFERED EMBODIMENTS

### First Embodiment

Structure of Semiconductor Integrated Circuit Device

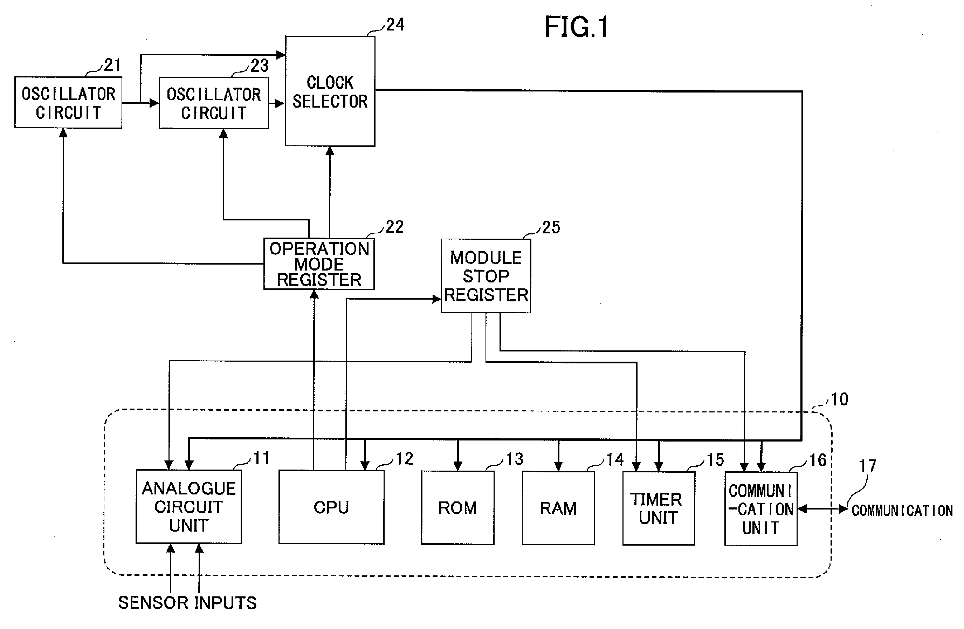

FIG. 1 is a block diagram showing a structure of a semiconductor integrated circuit device according to one embodiment of the present invention. According to FIG. 1, in a fuel gauge function module 10, an analogue circuit unit 11, a CPU 12, a ROM 13, a RAM 14, a timer unit 15 and a communication unit 16 are provided which are connected to one another using internal buses (not shown).

The analogue circuit unit 11 includes analogue circuits such as a voltage sensor, a temperature sensor, a current sensor and an A/D converter. A detection value of each sensor is converted by the A/D converter into a digital value, which is then transmitted to the CPU 12 via an internal bus.

The CPU 12 executes various types of software stored in the ROM 13, and sums the charging/discharging current of a lithium ion battery, detected by the current sensor to thereby calculate the remaining capacity of the lithium ion battery. Note that detection values obtained by the voltage sensor and temperature sensor are used for various corrections. The RAM 14 is used as a work area for the CPU 12 to execute processes. The ROM 13 includes an EEPROM non-volatile memory.

The timer unit 15 has various timers including an interrupt timer and a clock timer, and signals produced by these timers—e.g. an interrupt signal and a measurement time—are supplied to the CPU 12. The communication unit 16 reports the remaining battery capacity calculated by the CPU 12 to a battery-using appliance (such as a portable telephone or a digital camera) via a communication terminal 17 in response to a request sent from the battery-using appliance via the communication terminal 17.

An oscillator circuit 21 is instructed by an operation mode register 22 to oscillate or stop the oscillation according to an operation mode of the semiconductor integrated circuit device. In response to an oscillation instruction, the oscillator circuit 21 generates, for example, a low speed clock of 38.4 kHz, which is then supplied to an oscillator circuit 23 and a clock selector 24.

The oscillator circuit 23 includes a phase-locked loop (PLL), for example. When instructed by the operation mode register 22 to perform frequency multiplication according to the operation mode, the oscillator circuit 23 generates a medium/high speed clock having one of the frequencies of, for example, 5 MHz, 2.5 MHz and 1.25 MHz, which is synchronized with the clock output from the oscillator circuit 21, and supplies the medium/high speed clock to the clock selector 24.

Note that the clock output from the oscillator circuit 21 may not be supplied to the oscillator circuit 23, and the oscillator circuits 21 and 23 may operate out of sync.

When instructed by the operation mode register 22 to select a clock according to the operation mode, the clock selector 24 selects one among the low speed clock and the multiple medium/high speed clocks, and supplies the selected clock to each of the analogue circuit unit 11, the CPU 12, the ROM 13, the RAM 14, the timer unit 15 and the communication unit 16 of the fuel gauge function module 10.

The operation mode register 22 switches the current operation mode in response to when the CPU 12 sets a new operation mode in the operation mode register 22 and executes an instruction (sleep instruction). The CPU 12 sets in a module stop register 25 whether to allow or disallow each of the analogue circuit unit 11, the timer unit 15 and the communication unit 16 to receive a clock signal from the clock selector 24. Accordingly, the module stop register 25 transmits a signal indicating whether to allow the reception of the clock signal individually to the analogue circuit unit 11, the timer unit 15 and the communication unit 16. Herewith, among the analogue circuit unit 11, the timer unit 15 and the communication unit 16, only a component(s) which has been allowed the clock reception receives the clock signal supplied from the clock selector 24.

### Mode Switching

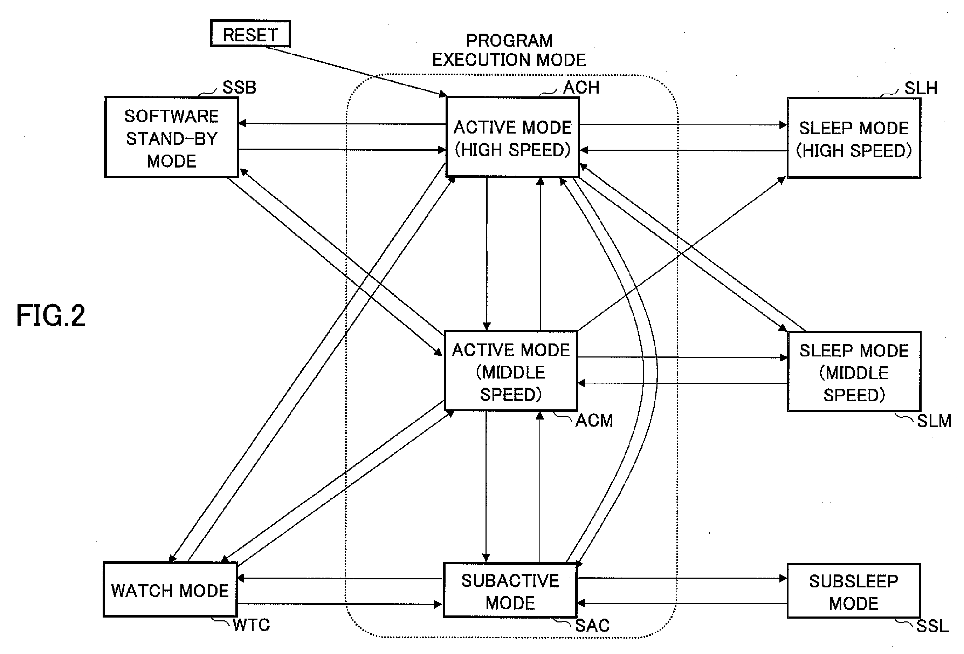

FIG. 2 shows mode switching of the semiconductor integrated circuit device of FIG. 1. According to FIG. 2, the semiconductor integrated circuit device enters an active mode (high speed) ACH by a reset. After this point, the semiconductor integrated circuit device enters an active mode (middle speed) ACM from the active mode (high speed) ACH in response to setting of a new operation mode made in the operation mode register 22 and an execution of a sleep instruction. A mode switch is also made in the reverse direction (i.e. from the active mode (middle speed) ACM to the active mode (high speed) ACH) in response to setting of a new operation mode made in the operation mode register 22 and an execution of a sleep instruction. The semiconductor integrated circuit device enters a subactive mode SAC from the active mode (middle speed) ACM in response to setting of a new operation mode made in the operation mode register 22 and an execution of a sleep instruction. A mode switch is also made in the reverse direction (i.e. from the subactive mode SAC to the active mode (middle speed) ACM) in response to setting of a new operation mode made in the operation mode register 22 and an execution of a sleep instruction.

The active mode (high speed) ACH is where the CPU 12 executes a program at high speed in accordance with a clock signal having a frequency of 5 MHz. The clock signal having a frequency of 5 MHz selected by the clock selector 24 is supplied to each component of the fuel gauge function module 10. By instructions from the module stop register 25, the analogue circuit unit 11, the timer unit 15 and the communication unit 16 operate at high speed by receiving the clock signal.

The active mode (middle speed) ACM is where the CPU 12 executes a program at middle speed in accordance with a clock signal having a frequency of 2.5 MHz or 1.25 MHz. The clock signal having a frequency of 2.5 MHz or 1.25 MHz selected by the clock selector 24 is supplied to each component of the fuel gauge function module 10. By instructions from the module stop register 25, the analogue circuit unit 11, the timer unit 15 and the communication unit 16 operate at a middle speed by receiving the clock signal.

The subactive mode SAC is where the CPU 12 executes a program at low speed in accordance with a clock of 38.4 kHz. The clock signal having a frequency of 38.4 kHz selected by the clock selector 24 is supplied to each component of the fuel gauge function module 10. By instructions from the module stop register 25, the analogue circuit unit 11, the timer unit 15 and the communication unit 16 operate at low speed by receiving the clock signal.

Also in response to setting of a new operation mode made in the operation mode register 22 and an execution of a sleep instruction, a mode switch can be made from the active mode (high speed) ACH to a sleep mode (high speed) SLH; from the active mode (middle speed) ACM to a sleep mode (middle speed) SLM; or from the subactive mode SAC to a subsleep mode SSL. For each of these mode switches, a reverse-direction mode switch is also made in response to an occurrence of a program interrupt or a timer interrupt.

The sleep mode (high speed) SLH is where the CPU 12 stops its operation, while by instructions from the module stop register 25, the analogue circuit unit 11, the timer unit 15 and the communication unit 16 operate by receiving the clock signal having a frequency of 5 MHz selected by the clock selector 24.

The sleep mode (middle speed) SLM is where the CPU 12 stops its operation, while by instructions from the module stop register 25, the analogue circuit unit 11, the timer unit 15 and the communication unit 16 operate by receiving the clock signal having a frequency of 2.5 MHz or 1.25 MHz selected by the clock selector 24.

The subsleep mode SSL is where the CPU 12 stops its operation, while by instructions from the module stop register 25, the analogue circuit unit 11, the timer unit 15 and the communication unit 16 operate by receiving the clock signal having a frequency of 38.4 kHz selected by the clock selector 24.

Also, in response to setting of a new operation mode made in the operation mode register 22 and an execution of a sleep instruction, a mode switch can be made from each of the active mode (high speed) ACH, the active mode (middle speed) ACM and the subactive mode SAC to a watch mode WTC or to a software stand-by mode SSB. For each of these mode switches, a reverse-direction mode switch is also made in response to an occurrence of a program interrupt or a timer interrupt.

The watch mode WTC is where the CPU 12 stops its operation, while by instructions from the module stop register 25, only the timer unit 15 operates by receiving the clock signal having a frequency of 38.4 kHz selected by the clock selector 24.

The software stand-by mode SSB is where the CPU 12 stops its operation, while by instructions from the module stop register 25, the analogue circuit unit 11, the timer unit 15 and the communication unit 16 all stop their operation.

In the watch mode WTC and the software stand-by mode SSB, when the analogue circuit unit 11, the RAM 14, the operation mode register 22, the module stop register 25 and the like stop their operations, each of these components retains its internal state.

Herewith, in the watch mode WTC, the timer unit 15 is capable of timing the period of time lapsing from the start of the watch mode WTC. Then, after a mode switch is made from the watch mode WTC to the active mode (high speed) ACH, the active mode (middle speed) ACM or the subactive mode SAC, the CPU 12 is able to estimate the charging/discharging current of the lithium ion battery based on the duration of the watch mode WTC.

### Switching of Operation Modes

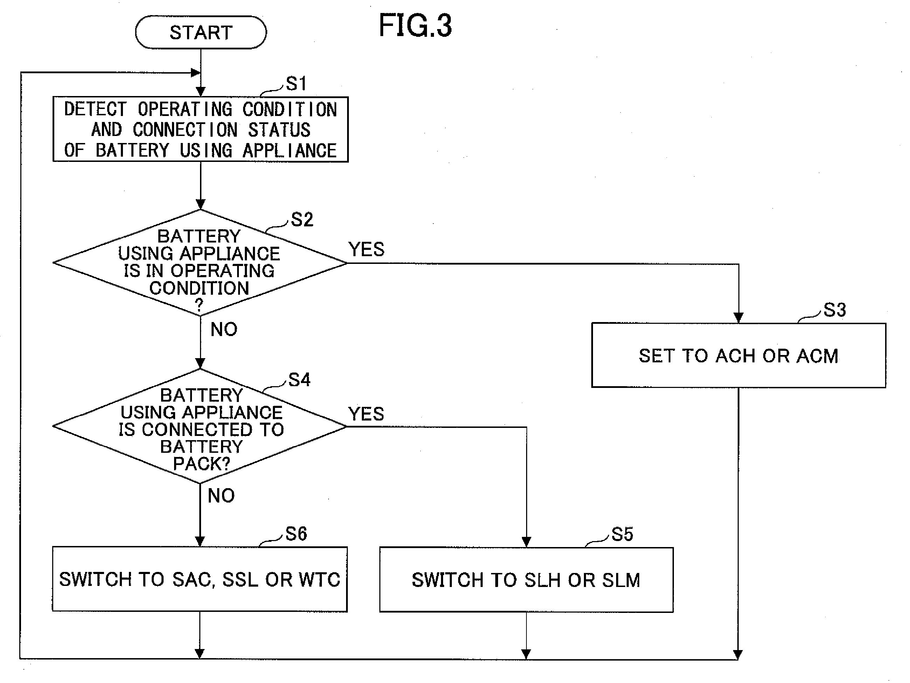

FIG. 3 is a flowchart showing one embodiment of an operation mode switching process performed by the CPU 12. Note that at the start of this process, the semiconductor integrated circuit device has been set to the active mode (high speed) ACH or the active mode (middle speed) ACM.

According to FIG. 3, the CPU 12 detects, via the communication unit 16, an operating condition of a battery-using appliance using the battery pack which includes the semiconductor integrated circuit device of the present embodiment, and a connection status of the battery-using appliance to the battery pack (Step S1). Specifically, the CPU 12 detects the frequency of the battery-using appliance to request the semiconductor integrated circuit device for information regarding the remaining battery capacity, and also detects the voltage at the communication terminal 17.

Based on the detection results (specifically, the frequency of requests for the remaining battery capacity information), the CPU 12 determines whether the battery-using appliance is in an active operating condition (Step S2). More specifically, in the case of being in the active operating condition, the battery-using appliance frequently requests the semiconductor integrated circuit device for the remaining battery capacity information via the communication unit 16. Accordingly, the CPU 12 determines that the battery-using appliance is in the active operating condition if the frequency of requests is equal to or more than a predetermined value, while determining negatively if the frequency of requests is less than the predetermined value. When determining affirmatively in Step S2, the CPU 12 then sets an operation mode to the active mode (high speed) ACH or the active mode (middle speed) ACM (Step S3).

On the other hand, if determining in Step S2 that the battery-using appliance is not in the active operating condition, the CPU 12 determines based on the detection results of Step S1 (specifically, the voltage at the communication terminal 17) whether the battery-using appliance is connected to the battery pack (Step S4). More specifically, in the case where the battery-using appliance is connected to the battery pack, the voltage at the communication terminal 17 reaches a predetermined level. Accordingly, if the voltage is at a predetermined level, the CPU 12 determines that the battery-using appliance is in a functionally-inactive condition in which the battery-using appliance is connected to the battery pack but is not in the active operating condition. In this case, the CPU 12 then switches the current operation mode to the sleep mode (high speed) SLH or to the sleep mode (middle speed) SLM (Step S5). When a predetermined period of time has elapsed after the switching, the operation mode returns to the original mode—i.e. the active mode (high speed) ACH, the active mode (middle speed) ACM or the subactive mode SAC—by, for example, a timer interrupt.

On the other hand, if determining in Step S4 that the voltage at the communication terminal 17 is not at the predetermined level, the CPU 12 determines that the battery-using appliance is not connected to the battery pack. Cases in which "the battery-using appliance is not connected to the battery pack" include, for example, when the battery pack is kept at the factory or the like prior to shipment or when the user has left the battery pack without mounting it on the battery-using appliance. In the case of determining that the battery-using appliance is not connected to the battery pack, the CPU 12 then switches the current operation mode to the subactive mode SAC, to the subsleep mode SSL or to the watch mode WTC (Step S6). When a predetermined period of time has elapsed after switching to the subsleep mode SSL or to the watch mode WTC, the operation mode returns to the original one-i.e. the active mode (high speed) ACH, the active mode (middle speed) ACM or the subactive mode SAC-by, for example, a timer interrupt.

Note that the user determines in advance which one of the active mode (high speed) ACH and the active mode (middle speed) ACM is to be set in Step S3; to which one of the sleep mode (high speed) SLH and the sleep mode (middle speed) SLM the operation mode is to be switched in Step S5; and to which one of the subactive mode SAC, the subsleep mode SSL or the watch mode WTC the operation mode is to be switched in Step S6. Then, the user stores such settings in the EEPROM of the ROM 13 in advance.

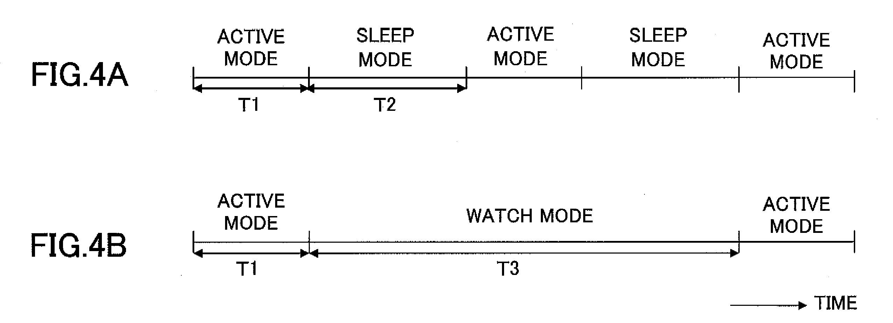

The semiconductor integrated circuit device may be designed such that, in the case when the battery-using appliance is connected to the battery pack but is not in the active operating condition (i.e. when in the functionally-inactive condition), the CPU 12 repeatedly changes the operation mode between the active mode (high speed) ACH (or the active mode (middle speed) ACM) for a predetermined period T1 and the sleep mode (high speed) SLH (or the sleep mode (middle speed) SLM) for a predetermined period T2, as shown in FIG. 4A.

Furthermore, the semiconductor integrated circuit device may be designed such that, in the case where the battery-using appliance is not connected to the battery pack, the CPU 12 repeatedly changes the operation mode between the active mode (high speed) ACH (or the active mode (middle speed) ACM, or the subactive mode SAC) for the predetermined period T1 and the watch mode WTC for a predetermined period T3, as shown in FIG. 4B. It is within the discretion of the user to set which operation mode is to be used in accordance with the condition of the battery-using appliance.

Thus, the semiconductor integrated circuit device is designed such that, according to the connection status and the operation condition of the battery-using appliance, the semiconductor integrated circuit device enters, for example, the active mode if the battery-using appliance is in the operating condition; the sleep mode if the battery-using appliance is not in the operating condition but is connected to the battery pack; and the watch mode if the battery-using appliance is not connected to the battery pack. Herewith, the semiconductor integrated circuit device of the present embodiment is capable of reducing the consumption current, and also obtaining the remaining battery capacity even when the battery pack is left for a long period of time without being connected to the battery-using appliance.

### Battery Pack

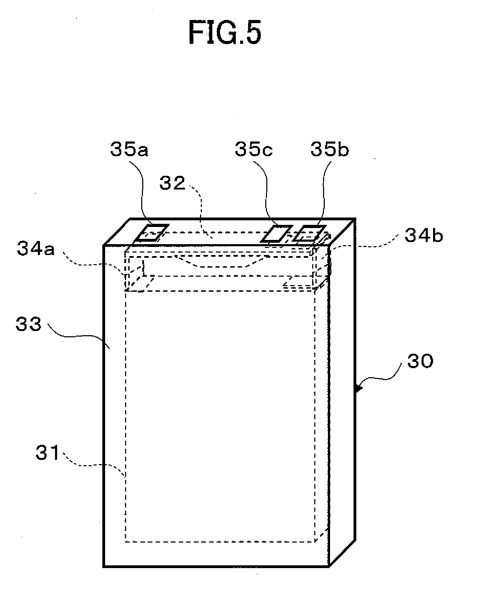

FIG. 5 is a perspective view of a battery pack to which the semiconductor integrated circuit device of one embodiment of the present invention is applied. According to FIG. 5, a battery pack 30 has a structure in which a battery 31 and a semiconductor integrated circuit device 32 are housed in a case 33. The battery 31 is a lithium ion battery, and is connected by connecting terminals 34a and 34b to the semiconductor integrated circuit device 32 having the structure shown in FIG. 1.

Note that external terminals 35a and 35b provided on the case 33 are connected to the positive electrode and the negative electrode, respectively, of the battery 31, while an external terminal 35c is connected to the communication terminal 17 of the semiconductor integrated circuit device 32.

Note that, in the above embodiment, the active modes are used as examples of the "first mode" as defined in the appended claims, while the sleep mode and the watch mode are used as examples of the "second mode" as defined in the appended claims.

### Second Embodiment

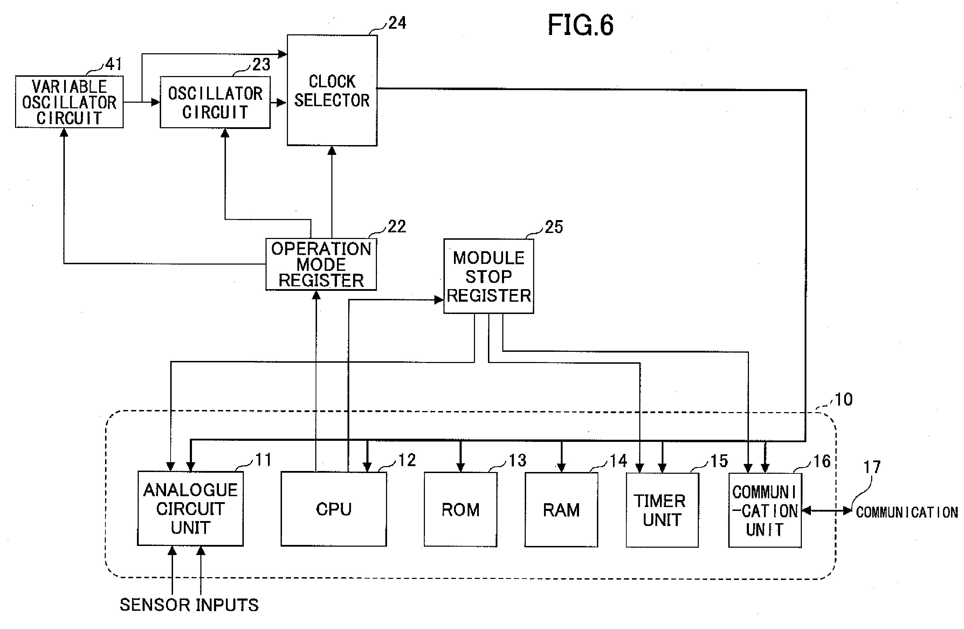

FIG. 6 is a block diagram showing a structure of a semiconductor integrated circuit device according the second embodiment of the present invention. In FIG. 6, the same reference numerals are given to the components which are common to the semiconductor integrated circuit device of FIG. 1. In the fuel gauge function module 10, the analogue circuit unit 11, the CPU 12, the ROM 13, the RAM 14, the timer unit 15 and the communication unit 16 are provided which are connected to one another using internal buses (not shown).

The analogue circuit unit 11 includes analogue circuits such as a voltage sensor, a temperature sensor, a current sensor and an A/D converter. A detection value of each sensor is converted by the A/D converter into a digital value, which is then transmitted to the CPU 12 via an internal bus.

The CPU 12 executes various types of software stored in the ROM 13, and sums the charging/discharging current of a lithium ion battery, detected by the current sensor to thereby calculate the remaining capacity of the lithium ion battery. Note that detection values obtained by the voltage sensor and temperature sensor are used for various corrections. The RAM 14 is used as a work area for the CPU 12 to execute processes. The ROM 13 includes an EEPROM non-volatile memory.

The timer unit 15 has various timers including an interrupt timer and a clock timer, and signals produced by these timers—e.g. an interrupt signal and a measurement time-are supplied to the CPU 12. The communication unit 16 reports the remaining battery capacity calculated by the CPU 12 to a battery-using appliance (such as a portable telephone or a digital camera) via the communication terminal 17 in response to a request sent from the battery-using appliance via the communication terminal 17.

A variable oscillator circuit 41 is instructed by the operation mode register 22 to oscillate at a frequency according to an operation mode of the semiconductor integrated circuit device or to stop the oscillation. For example, in response to an oscillation instruction 1 (active mode, subactive mode, sleep mode and subsleep mode), the variable oscillator circuit 41 generates a low speed clock signal having a frequency of 38.4 kHz. In response to an oscillation instruction 2 (watch mode), the variable oscillator circuit 41 generates an ultralow speed clock signal having a frequency of of 9.6 kHz or less. The generated clock is then supplied to the oscillator circuit 23 and the clock selector 24.

It may be the case that the A/D converter in the analogue circuit unit 11 is performed by a sigma-delta modulator. In this case, the sigma-delta modulator modulates analogue signals into PDM (pulse density modulated) signals, i.e. 1-bit digital modulated signals, which are then supplied to the CPU 12. The CPU 12 converts the PDM signals into multi-bit digital values, i.e. PCM (pulse code modulated) data. Under this configuration, the CPU 12 can convert PDM signals into PCM data if the low speed clock signal having a frequency of 38.4 kHz is supplied; however, the CPU 12 cannot perform this conversion with the ultralow speed clock signal having a frequency of 9.6 kHz. That is, the ultralow speed clock signal having a frequency of 9.6 kHz is such an ultralow speed that the CPU 12 cannot perform its normal operation.

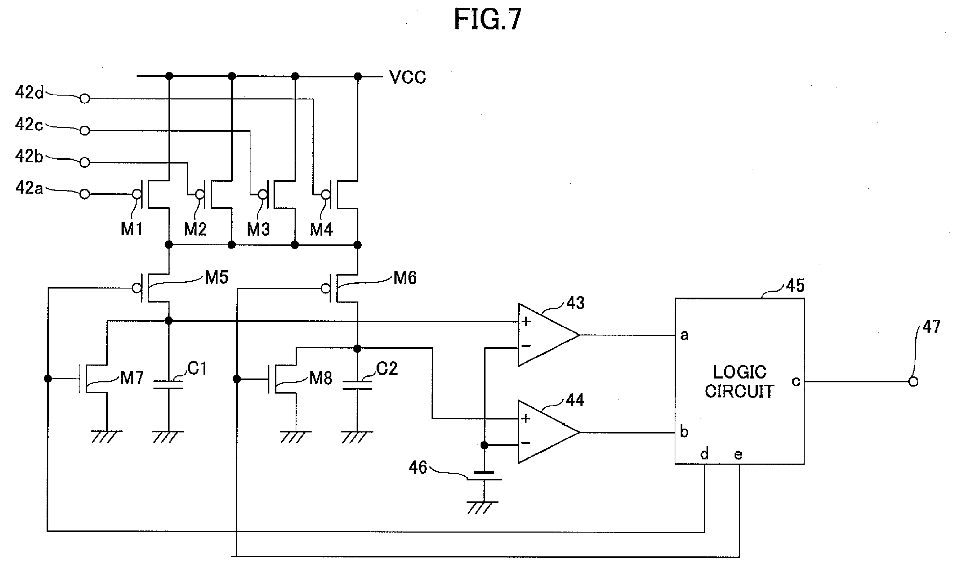

FIG. 7 shows a configuration of the variable oscillator circuit 41 according to one embodiment of the present invention. In FIG. 7, as for the p-channel MOS-FETs (metal-oxide semiconductor field-effect transistors; hereinafter, referred to as "MOS transistors") M1-M4, the sources are connected to power Vcc, the gates are connected to terminals 42a-42d, and the drains are commonly connected. To the drains of the MOS transistors M1-M4, the sources of p-channel MOS transistors M5 and M6 are connected. The drain currents obtained when the MOS transistors M1-M4 are ON are designed to be equal to each other.

The drain of the MOS transistor M5 is connected to the non-inverting input terminal of a comparator 43, the drain of an n-channel MOS transistor M7, and a terminal of a capacitor C1. The source of the MOS transistor M7 and the other terminal of the capacitor C1 are grounded. The gates of the MOS transistors M5 and M7 are connected to a terminal d of a logic circuit 45. A reference voltage V1 from a constant voltage source 46 is applied to the inverting input terminal of the comparator 43. The output terminal of the comparator 43 is connected to a terminal a of the logic circuit 45.

The drain of the MOS transistor M6 is connected to the non-inverting input terminal of a comparator 44, the drain of an n-channel MOS transistor M8, and a terminal of a capacitor C2 (for example, C1 = C2). The source of the MOS transistor M8 and the other terminal of the capacitor C2 are grounded. The gates of the MOS transistors M6 and M8 are connected to a terminal e of the logic circuit 45. The reference voltage V1 from the constant voltage source 46 is applied to the inverting input terminal of the comparator 44. The output terminal of the comparator 44 is connected to a terminal b of the logic circuit 45.

Under this configuration, if, in the logic circuit 45, the output of the terminal e becomes high level and the output of the terminal d becomes low level, the MOS transistor M5 turns ON and the MOS transistor M7 turns OFF, whereby the capacitor C1 is charged. Accordingly, the voltage at the non-inverting input terminal of the comparator 43 gradually increases, and when the increasing voltage exceeds the reference voltage V1, the output of the comparator 43 (i.e. the input of the terminal a of the logic circuit 45) is changed from low level to high level. Herewith, the output of a terminal c becomes high level and the output of the terminal d also becomes high level. Subsequently, the MOS transistor M5 turns OFF and the MOS transistor M7 turns ON, whereby the capacitor C1 is rapidly discharged.

If the output of the terminal d becomes high level and the output of the terminal e becomes low level, the MOS transistor M6 turns ON and the MOS transistor M8 turns OFF, whereby the capacitor C2 is charged. Accordingly, the voltage at the non-inverting input terminal of the comparator 44 gradually increases, and when the increasing voltage exceeds the reference voltage V1, the output of the comparator 44 (i.e. the input of the terminal b of the logic circuit 45) is charged from low level to high level. Herewith, the output of the terminal c becomes low level and the output of the terminal e becomes high level. Subsequently, the MOS transistor M6 turns OFF and the MOS transistor M8 turns ON, whereby the capacitor C2 is rapidly discharged. In this manner, the output of the terminal c of the logic circuit 45 is output from a terminal 47 as an oscillation signal.

In the case of receiving the oscillation instruction 1 which indicates to generate the low speed clock signal having a frequency of 38.4 kHz, low-level signals are supplied to all the terminals 42a-42d, and the MOS transistors M1-M4 turn ON. The sum of the drain currents of the MOS transistors M1-M4 corresponds to the drain current of the MOS transistor M5 or M6, i.e. the charging current of the capacitor C1 or C2.

In the case of receiving the oscillation instruction 2 which indicates to generate the ultralow speed clock signal having a frequency of 9.6 kHz, a low-level signal is supplied only to the terminal 42a while high-level signals are supplied to the terminals 42b-42d, and therefore, only the MOS transistor M1 turns ON. Accordingly, the drain current of the MOS transistor M1 corresponds to the drain current of the MOS transistor M5 or M6, i.e. the charging current of the capacitor C1 or C2.

Thus, in the case of receiving the oscillation instruction 2, the charging current of the capacitor C1 or C2 becomes one quarter of the as compared to the case of receiving the oscillation instruction 1, and herewith, the oscillation frequency is made around one quarter of the oscillation frequency of the clock signal generated in response to the oscillation instruction 1.

Note that the variable oscillator circuit 41 may be designed to have an oscillator for generating the low speed clock signal and an oscillator for generating the ultralow speed clock signal and switch over these two oscillators.

The oscillator circuit 23 includes a phase-locked loop (PLL), for example. When instructed by the operation mode register 22 to perform frequency multiplication according to the operation mode, the oscillator circuit 23 generates a medium/high speed clock having one of the frequencies of, for example, 5 MHz, 2.5 MHz and 1.25 MHz, which is synchronized with the clock output from the variable oscillator circuit 41, and supplies the medium/high speed clock to the clock selector 24.

Note that the clock output from the variable oscillation circuit 41 may not be supplied to the oscillator circuit 23, and the oscillator circuits 41 and 23 may operate out of sync.

When instructed by the operation mode register 22 to select a clock according to the operation mode, the clock selector 24 selects one among the low speed clock and the multiple medium/high speed clocks, and supplies the selected clock to each of the analogue circuit unit 11, the CPU 12, the ROM 13, the RAM 14, the timer unit 15 and the communication unit 16 of the fuel gauge function module 10.

The operation mode register 22 switches the current operation mode in response to when the CPU 12 sets a new operation mode in the operation mode register 22 and executes an instruction (sleep instruction). The CPU 12 sets in a module stop register 25 whether to allow or disallow each of the analogue circuit unit 11, the timer unit 15 and the communication unit 16 to receive a clock signal from the clock selector 24. Accordingly, the module stop register 25 transmits a signal indicating whether to allow the reception of the clock signal individually to the analogue circuit unit 11, the timer unit 15 and the communication unit 16. Herewith, among the analogue circuit unit 11, the timer unit 15 and the communication unit 16, only a component(s) which has been allowed the clock reception receives the clock signal supplied from the clock selector 24.

### Mode Switching

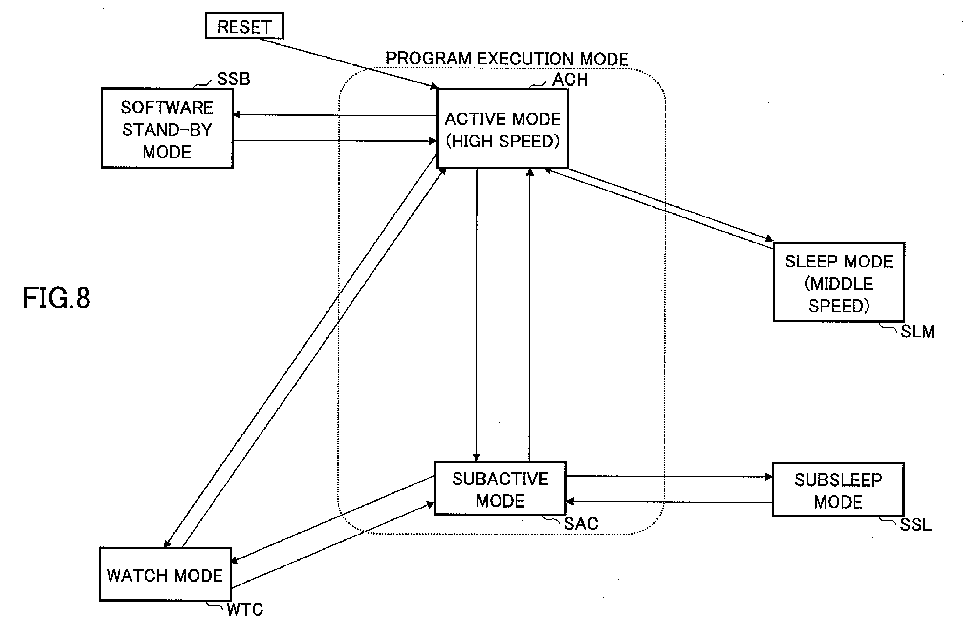

FIG. 8 shows mode switching of the semiconductor integrated circuit device of FIG. 6. Note that in FIG. 8, the longitudinal direction represents the clock frequency. According to FIG. 8, the semiconductor integrated circuit device enters the active mode (high speed) ACH by a reset. After this point, the semiconductor integrated circuit device enters the subactive mode SAC from the active mode (high speed) ACH in response to setting of a new operation mode made in the operation mode register 22 and an execution of a sleep instruction. A mode switch is also made in the reverse direction (i.e. from the subactive mode SAC to the active mode (high speed) ACH) in response to setting of a new operation mode made in the operation mode register 22 and an execution of a sleep instruction.

The active mode (high speed) ACH is where the CPU 12 executes a program at high speed in accordance with a clock signal having a frequency of 5 MHz. The clock signal having a frequency of 5 MHz selected by the clock selector 24 is supplied to each component of the fuel gauge function module 10. By instructions from the module stop register 25, the analogue circuit unit 11, the timer unit 15 and the communication unit 16 operate at high speed by receiving the clock signal.

The subactive mode SAC is where the CPU 12 executes a program at low speed in accordance with a clock of 38.4 kHz. The clock signal having a frequency of 38.4 kHz selected by the clock selector 24 is supplied to each component of the fuel gauge function module 10. By instructions from the module stop register 25, the analogue circuit unit 11, the timer unit 15 and the communication unit 16 operate at low speed by receiving the clock signal.

Also in response to setting of a new operation mode made in the operation mode register 22 and an execution of a sleep instruction, a mode switch can be made from the active mode (high speed) ACH to the sleep mode (middle speed) SLM. A mode transition is also made in the reverse direction (i.e. from the sleep mode (middle speed) SLM to the active mode (high speed) ACH) in response to an occurrence of a program interrupt or a timer interrupt.

The sleep mode (middle speed) SLM is where the CPU 12 stops its operation, while by instructions from the module stop register 25, the analogue circuit unit 11, the timer unit 15 and the communication unit 16 operate by receiving the clock signal having a frequency of 2.5 MHz or 1.25 MHz selected by the clock selector 24.

Also in response to setting of a new operation mode made in the operation mode register 22 and an execution of a sleep instruction, a mode switch can be made from the subactive mode SAC to the subsleep mode SSL. A mode transition is also made in the reverse direction (i.e. from the subsleep mode SSL to the subactive mode SAC) in response to an occurrence of a program interrupt or a timer interrupt.

The subsleep mode SSL is where the CPU 12 stops its operation, while by instructions from the module stop register 25, the analogue circuit unit 11, the timer unit 15 and the communication unit 16 operate by receiving the clock signal having a frequency of 38.4 kHz selected by the clock selector 24.

Also in response to setting of a new operation mode made in the operation mode register 22 and an execution of a sleep instruction, a mode switch can be made from the active mode (high speed) ACH to the watch mode WTC or to the software stand-by mode SSB. For each of these mode switches, a reverse-direction mode switch is also made in response to an occurrence of a program interrupt or a timer interrupt.

The watch mode WTC is where the CPU 12 stops its operation, while by instructions from the module stop register 25, only the timer unit 15 operates by receiving the clock signal having a frequency of 9.6 kHz selected by the clock selector 24.

The software stand-by mode SSB is where the CPU 12 stops its operation, while by instructions from the module stop register 25, the analogue circuit unit 11, the timer unit 15 and the communication unit 16 all stop their operations.

In the watch mode WTC and the software stand-by mode SSB, when the analogue circuit unit 11, the RAM 14, the operation mode register 22, the module stop register 25 and the like stop their operations, each of these components retains its internal state.

Herewith, in the watch mode WTC, the timer unit 15 is capable of timing the period of time lapsing from the start of the watch mode WTC. Then, after a mode switch is made from the watch mode WTC to the subactive mode SAC, the CPU 12 is able to estimate the charging/discharging current of the lithium ion battery based on the duration of the watch mode WTC.

### Switching of Operation Modes

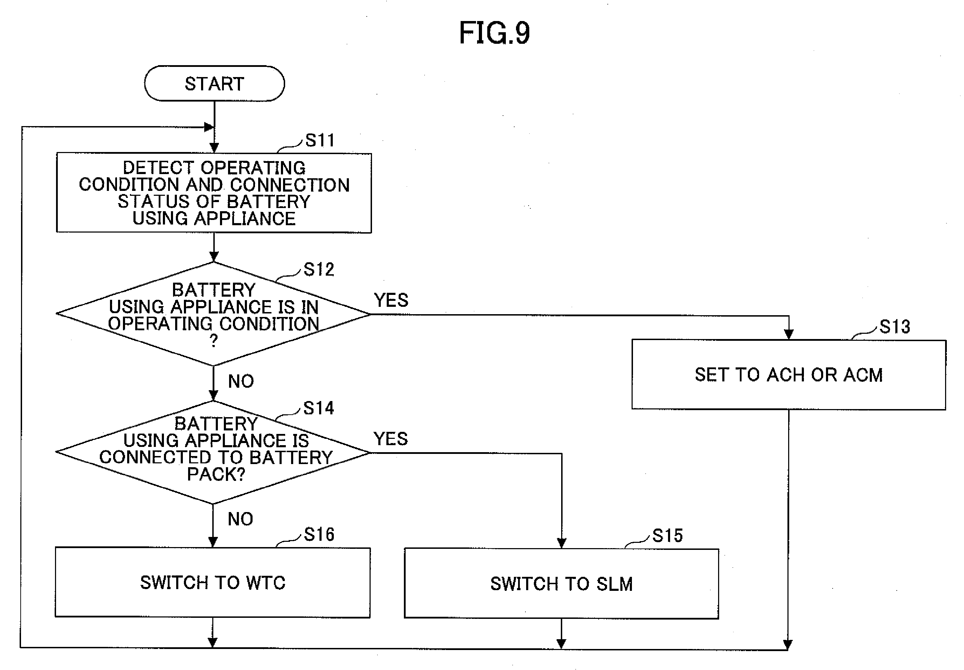

FIG. 9 is a flowchart showing one embodiment of an operation mode switching process performed by the CPU 12. Note that at the start of this process, the semiconductor integrated circuit device has been set to the active mode (high speed) ACH or the active mode (middle speed) ACM.

According to FIG. 9, the CPU 12 detects, via the communication unit 16, an operating condition of a battery-using appliance using the battery pack which includes the semiconductor integrated circuit device, and a connection status of the battery-using appliance to the battery pack (Step S11). Specifically, the CPU 12 detects the frequency of the battery-using appliance to request the semiconductor integrated circuit device for information regarding the remaining battery capacity, and also detects the voltage at the communication terminal 17.

Based on the detection results (specifically, the frequency of requests for the remaining battery capacity information), the CPU 12 determines whether the battery-using appliance is in an active operating condition (Step S12). More specifically, in the case of being in the active operating condition, the battery-using appliance frequently requests the semiconductor integrated circuit device for the remaining battery capacity information via the communication unit 16. Accordingly, the CPU 12 determines that the battery-using appliance is in the active operating condition if the frequency of requests is equal to or more than a predetermined value, while determining negatively if the frequency of requests is less than the predetermined value. When determining affirmatively in Step S12, the CPU 12 then sets an operation mode to the active mode (high speed) ACH (Step S13).

On the other hand, if determining in Step S12 that the battery-using appliance is not in the active operating condition, the CPU 12 determines based on the detection results of Step S11 (specifically, the voltage at the communication terminal 17) whether the battery-using appliance is connected to the battery pack (Step S14). More specifically, in the case where the battery-using appliance is connected to the battery pack, the voltage at the communication terminal 17 reaches a predetermined level. Accordingly, if the voltage is at a predetermined level, the CPU 12 determines that the battery-using appliance is in a functionally-inactive condition in which the battery-using appliance is connected to the battery pack but is not in the active operating condition. In this case, the CPU 12 then switches the current operation mode to the sleep mode (middle speed) SLM (Step S15). When a predetermined period of time has elapsed after the switching, the operation mode returns to the original mode-i.e. the active mode (high speed) ACH-by, for example, a timer interrupt.

On the other hand, if determining in Step S14 that the voltage at the communication terminal 17 is not at the predetermined level, the CPU 12 determines that the battery-using appliance is not connected to the battery pack. Cases in which "the battery-using appliance is not connected to the battery pack" include, for example, when the battery pack is kept at the factory or the like prior to shipment or when the user has left the battery pack without mounting it on the battery-using appliance. In the case of determining that the battery-using appliance is not connected to the battery pack, the CPU 12 then switches the current operation mode to the watch mode WTC (Step S16). After switching to the watch mode WTC, the timer unit 15 counts the ultralow clock signal having a frequency of 9.6 kHz. Then, when a predetermined period of time has elapsed, the operation mode returns to the original one-i.e. the active mode (high speed) ACH or the subactive mode SAC by a timer interrupt generated by the timer unit 15.

Note that, in Step S16, the current operation mode may be switched to the subactive mode SAC or the subsleep mode SSL, instead of to the watch mode WTC.

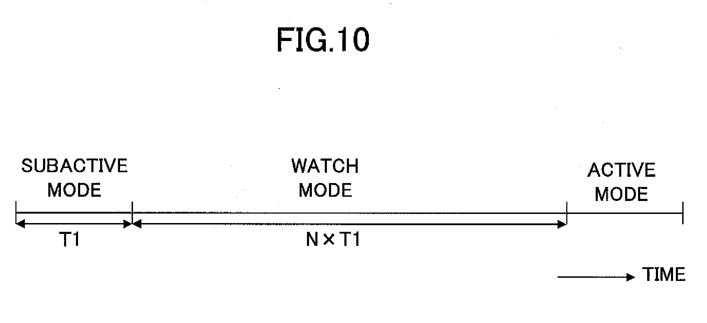

In the present embodiment, the semiconductor integrated circuit device may be designed such that, in the case where the battery-using appliance is not connected to the battery pack, the CPU 12 repeatedly changes the operation mode between the subactive mode SAC for the predetermined period T1 and the watch mode WTC for a predetermined period N×T1 (N is a real number), as shown in FIG. 10.

In this case, the semiconductor integrated circuit device is designed such that, as for the variable N, a default value is set in the EEPROM of the ROM 13 at the time of manufacture, and later when the battery-using appliance is connected to the battery pack, the setting of the variable N can be changed via the battery-using appliance. Herewith, the duration of the watch mode WTC can be freely changed in accordance with the operating condition of the battery-using appliance.

Thus, the second embodiment allows the consumption current to be reduced using the ultralow speed clock signal having a frequency of, for example, 9.6 kHz or less in the watch mode. For example, even if the battery-using appliance is not connected to the battery pack, the semiconductor integrated circuit device is capable of calculating the remaining battery charge by entering the subactive mode periodically. Accordingly, by reducing the consumption current, it is possible to extend the operating life of the battery pack.

Note that, in the second embodiment, the active modes and the subactive mode are used as examples of the "third mode" as defined in the appended claims, while the watch mode is used as an example of the "fourth mode" as defined in the appended claims.

Although the invention has been described with respect to specific embodiments for a complete and clear disclosure, the appended claims are not to be thus limited but are to be construed as embodying all modifications and alternative constructions that may occur to one skilled in the art that fairly fall within the basic teachings herein set forth.

This patent application is based on Japanese Priority Patent Applications No. 2007-316283 filed on December 6, 2007 and No. 2008-272909 filed on October 23, 2008, the entire contents of which are hereby incorporated herein by reference.

## Claims

1. A semiconductor integrated circuit device for calculating a remaining battery capacity of a battery from which the semiconductor integrated circuit device receives power supply thereof, and reporting the calculated remaining battery capacity to a battery-using appliance which also receives power supply thereof from the battery, the semiconductor integrated circuit device comprising:
a clock generating unit configured to generate a first clock signal and a second clock signal having a higher frequency than a frequency of the first clock signal;
a selecting unit configured to select one of the first clock signal and the second clock signal and output the selected clock signal;
a calculating unit configured to operate according to the selected clock signal to calculate the remaining battery capacity; and
a communicating unit configured to operate according to the selected clock signal to report the calculated remaining battery capacity to the battery-using appliance.

2. The semiconductor integrated circuit device as claimed in claim 1, further comprising a setting unit configured to put the calculating unit into one of a first mode in which the calculating unit operates and a second mode in which the calculating unit remains in a sleep state.

3. The semiconductor integrated circuit device as claimed in claim 1, wherein the calculating unit determines a connection status of the battery-using appliance to the battery, the selecting unit selects the second clock signal in a case where the calculating unit determines that the battery-using appliance is connected to the battery, and selects the first clock signal in a case where the calculating unit determines that the battery-using appliance is not connected to the battery.

4. The semiconductor integrated circuit device as claimed in claim 1, wherein the clock generating unit includes a first oscillator generating the first clock signal and a second oscillator generating the second clock signal in such a manner that the second clock signal is synchronized with the first clock signal.

5. The semiconductor integrated circuit device as claimed in claim 1, wherein the clock generating unit includes a first oscillator generating the first clock signal and a second oscillator generating the second clock signal in such a manner that the second clock signal is out of sync with the first clock signal.

6. The semiconductor integrated circuit device as claimed in claim 2, wherein the calculating unit determines a connection status of the battery-using appliance to the battery, wherein the selecting unit selects the second clock signal in a case where the calculating unit determines that the battery-using appliance is connected to the battery, and selects the first clock signal in a case where the calculating unit determines that the battery-using appliance is not connected to the battery.

7. The semiconductor integrated circuit device as claimed in claim 6, wherein the calculating unit further determines an operating condition of the battery-using appliance, and the setting unit switches the calculating unit between the first mode and the second mode according to the connection status and the operation condition determined by the determining unit.

8. The semiconductor integrated circuit device as claimed in claim 2, further comprising a timing unit configured to, while operating according to the selected clock signal, time a period of time in the second mode.

9. The semiconductor integrated circuit device as claimed in claim 1, further comprising:
a timing unit configured to time a period of time using the selected clock signal; and
a setting unit configured to put the calculating unit into one of a third mode in which the calculating unit operates and a fourth mode in which the calculating unit remains in a sleep state and only the timing unit operates;
wherein the clock generating unit includes a first oscillator that generates the first clock signal and a second oscillator that generates the second clock signal, and
the first oscillator generates the first clock signal in such a manner that the frequency of the first clock signal is lower in the fourth mode than in the third mode.

10. The semiconductor integrated circuit device as claimed in claim 9, wherein the timing unit times a period of time in the fourth mode using the first clock signal, and causes the setting unit to put the calculating unit into the third mode upon a passage of a predetermined time period.

11. The semiconductor integrated circuit device as claimed in claim 10, wherein the timing unit is able to freely change the predetermined time period.

12. A battery pack comprising:
a battery; and
a semiconductor integrated circuit device that receives power supply thereof from the battery to calculate a remaining battery capacity of the battery and report the calculated remaining battery capacity to a battery-using appliance which also receives power supply thereof from the battery, the semiconductor integrated circuit device including a clock generating unit configured to generate a first clock signal and a second clock signal having a higher frequency than a frequency of the first clock signal; a selecting unit configured to select one of the first clock signal and the second clock signal and output the selected clock signal; a calculating unit configured to operate according to the selected clock signal to calculate the remaining battery capacity; and a communicating unit configured to operate according to the selected clock to report the calculated remaining battery capacity to the battery-using appliance.
